Europäisches Patentamt

European Patent Office

Office européen des brevets

(19)

(11) Publication number: **0 151 267**
**B1**

## EUROPEAN PATENT SPECIFICATION

(12)

(45) Date of publication of patent specification: **27.07.88**

(51) Int. Cl.⁴: **H 01 L 27/02**

(21) Application number: **84115019.6**

(22) Date of filing: **11.12.84**

(54) VLSI integrated circuit having improved density.

(30) Priority: **30.12.83 US 567020**

(43) Date of publication of application:
**14.08.85 Bulletin 85/33**

(45) Publication of the grant of the patent:
**27.07.88 Bulletin 88/30**

(84) Designated Contracting States:
**DE FR GB**

(56) References cited:
**EP-A-0 001 209**
**EP-A-0 021 661**
**DE-A-2 823 555**
**US-A-3 365 707**
**US-A-4 295 149**

(73) Proprietor: **International Business Machines
Corporation
Old Orchard Road
Armonk, N.Y. 10504 (US)**

(72) Inventor: **Askin, Haluk Ozdemir
Route 82
Clinton Corners, N.Y. 12514 (US)**
Inventor: **Balyoz, John
Deerwood Drive
Hopewell Junction, N.Y. 12533 (US)**
Inventor: **Beaty, Doyle Edmund, Jr.
31F Sherwood Forest
Wappingers Falls, N.Y. 12590 (US)**
Inventor: **Cavaliere, Joseph Richard
Roural Route Nr. 7 Box 74
Hopewell Junction, N.Y. 12533 (US)**
Inventor: **Rabbat, Guy
32 Tor Road
Wappingers Falls, N.Y. 12590 (US)**
Inventor: **Sarris, Achilles Aristotle
6G Fishkill Part Apartments Route 52
Fishkill, N.Y. 12524 (US)**

(74) Representative: **Mönig, Anton, Dipl.-Ing.
IBM Deutschland GmbH Schönaicher Strasse
220
D-7030 Böblingen (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a VLSI (Very Large Scale Integration) integrated circuit having a significantly improved circuit density. More particularly, the invention pertains to such a VLSI circuit composed of a plurality of identical "multicells", each of which is identical to all other cells and each of which is composed of a number of transistors, diodes and resistors which are only partially interconnected prior to final device fabrication so that the various cells can be selectively configured in a desired logic circuit configuration and multiple ones of the cells can be connected together to implement any desired function. That is, the cells are not limited to any particular logic circuit configuration.

In general, to fabricate a VLSI device, a large chip, referred to as a "masterslice" is first produced. The masterslice will have formed thereon a number of logic circuits, typically OR, NOR, AND, NAND and EXCLUSIVE-OR gates, inverters, multiplexers, and the like. The book "Integrated Circuits, A Basic Course for Engineers and Technicians", R. G. Hibberd, McGraw-Hill Book Company, 1969, pp. 136—142, gives a good general discussion of such devices. The masterslices are stocked, and then later the various logic circuits thereon are wired together in a desired configuration to provide a logic circuit system which will perform a desired digital processing function.

This approach, although capable of yielding VLSI devices which will perform as desired, is nevertheless disadvantageous in that it is not possible to produce any one masterslice in which all of the logic circuits thereon can be used in all possible applications. That is, there is generally a relatively great waste of chip area because a large number of the logic circuits cannot be used in any given application.

United States Patent No. 4,255,672 to Ohno et al, describes an improvement over the above-described basic technique wherein a plurality of identical emitter-coupled logic circuit cells are fabricated upon a single chip. In addition to the logic circuit cells, there are also fabricated upon the same chip a plurality of driver circuits composed of larger transistors having a greater drive capability than the transistors of which the logic circuit cells are composed. Although the approach of Ohno et al. may lead to some improvement in integration density, nonetheless, the approach suffers significant drawbacks in that the driver circuits take up a large portion of the overall available chip area. Also, complex wiring techniques must be employed to make connections between the ordinary logic circuit cells and the driver circuits since the positional interrelationship between the logic circuit cells and the driver circuits cannot be optimum for all applications.

The invention as claimed solves the problem of how to provide a VLSI integrated circuit in which maximum utilization is made of all circuit cells on the chip. Further, the invention allows to provide such a VLSI integrated circuit in which no complex wiring patterns are required to configure the logic circuit cells in the desired pattern.

These, as well as other objects of the invention, are met by a semiconductor integrated circuit chip (masterslice) comprising a plurality of identical cells i.e. multicells arranged in a matrix of columns and rows. Each of the cells includes a plurality of diffused areas on the surface of the chip, with the diffused areas forming both active and passive semiconductor devices or elements. The semiconductor elements employed with the invention are not complete logic circuits at the time that the initial fabrication of the chip is completed, but are only elements such as transistors and diodes (active elements) and resistors (passive elements). Some of these elements may be partially interconnected. It is only when the chip is ready to be configured into a particular logic circuit system, which includes higher-level logic circuits such as adders, registers, comparators and the like, that the various circuit elements that make up the cells are completely interconnected.

A plurality of connectors are formed on the surface of the chip. These connectors, which are preferably made of polysilicon material, have bonding areas (pads) which are located in parallel lines on the surface of the chip. This leaves space for wiring channels between lines of connector bonding areas on the surface of the chip.

Some of the bonding areas of some of the connectors may be coupled to predetermined ones of the semiconductor elements, although most of the bonding areas of the connectors should be left unconnected to provide maximum flexibility in circuit configuration when the cell is finally wired up in a desired logic circuit configuration. It is also preferred that the active and passive elements be formed on the chip in alignment with the bonding areas of the connectors to provide for maximum room between the lines of bonding areas of the connectors for later use by the metallization layers.

In a preferred embodiment, each cell is provided with two transistors, four diodes and four resistors. It has been found that this configuration provides a very high utilization rate of circuit elements among cells so that there is very little waste of circuit elements when the device is connected in the final desired logic circuit system configuration. In this preferred embodiment, the bonding areas are arranged along three lines, one running lengthwise through the approximate middle of the cell, and two running lengthwise on opposite sides of the cell. The two transistors are aligned with the bonding areas on one side of the cell, and the diodes aligned with the bonding areas on the other side of the cell. The resistors are aligned with the bonding areas which fall along the line running through the approximate middle of the cell. In this case, it is preferred that some of the connectors which do not have bonding areas already connected to any of the circuit elements to be placed about in the middle of the

cell and running orthogonal to the lines of bonding areas on the two sides of the cell. The four resistors may be formed as two diffused areas which have center taps at bonding areas of two of the connectors.

Chips having the above-described configuration may be stocked. Later, when it is desired to wire the various cells together in a particular desired logic circuit system configuration, one or more metallization layers can be formed to interconnect the circuit elements of the various cells and multiple ones of the cells together to achieve the needed logic function.

In the following an embodiment of the invention is described with reference to the drawings in which:

Fig. 1 is a top plan view of a single cell of a semiconductor integrated circuit chip of the invention;

Fig. 2 is a cross-sectional view taken through a portion of the chip of Fig. 1;

Fig. 3 is a circuit diagram of the cell of Fig. 1;

Fig. 4 is a circuit diagram showing two of the cells of Fig. 1 wired together to form a storage cell; and

Figs. 5A and 5B are top views of wiring patterns used to form the circuit of Fig. 4 employing two laterally adjacent cells of the type of Fig. 1.

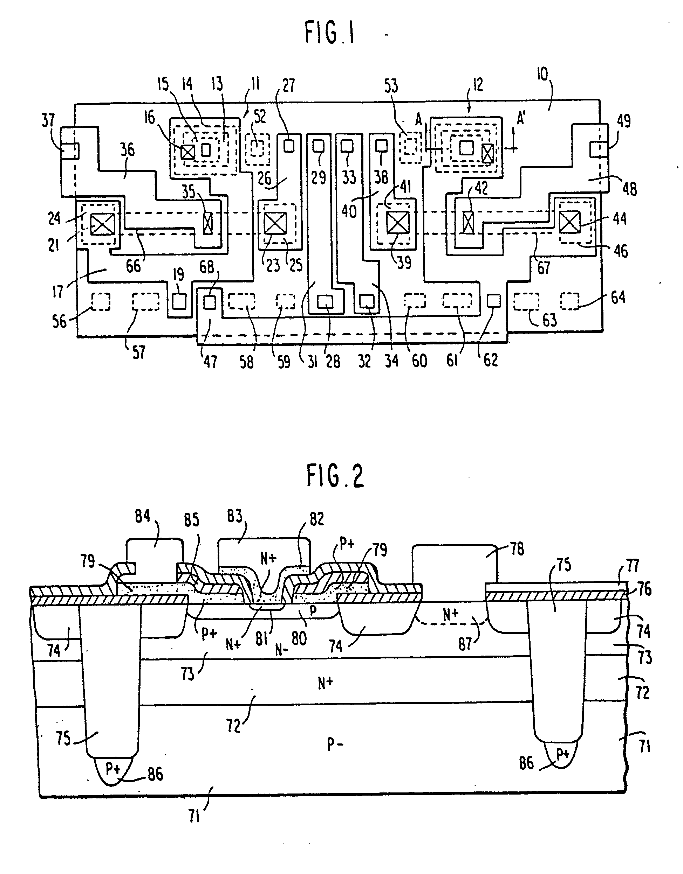

Referring now to Fig. 1 of the drawings, there is shown therein a top plan view of a single cell of a semiconductor integrated circuit chip of the invention. There would of course be many more such cells, and the cells would be arranged in a matrix of columns and rows. However, only a single cell is shown here for convenience as all of the cells of the matrix of cells are identical.

The cell is constructed upon a semiconductor epitaxial layer 10, which may be formed of n⁻ silicon material. The cell includes two transistors 11 and 12 fabricated using ordinary integrated circuit techniques. The transistor 11, for instance, has an emitter region 15 surrounded by a base region 13. The base region 13 is, in turn, surrounded by a channel stop region 14 of an insulating material. This construction will be described in more detail below with reference to the cross-sectional view of Fig. 2. The structure of the transistor 12 is identical to that of the transistor 11.

Four diodes are also formed in the surface of the epitaxial layer 10. A first of these diodes has an anode 57 and a cathode 56, a second of the diodes has an anode 58 and a cathode 59, a third of the diodes has an anode 61 and a cathode 60, and a fourth of the diodes has an anode 63 and a cathode 64. In the state of fabrication of the device shown in Fig. 1, none of the anodes or cathodes of any of the diodes are connected to any of the other circuit elements.

Between the transistors on one side of the cell and the diodes on the other side of the cell are formed two diffusions 66 and 67 which are used as resistors. The diffusions extend generally parallel to the long sides of the rectangular cell.

Polysilicon connectors 17, 26, 34, 40, 47 and 48 are formed on the surface of the substrate 10 in the pattern shown. The connectors 17, 26, 34, 40, 47 and 48 are of course insulated from the substrate 10 except in the areas marked by "X". The connector 36 has a bonding area 37 at one end and is connected via a bonding area 35 to approximately the midpoint of the diffusion 66. The left end of the connector 17 is connected via a bonding area 21 to the left end of the diffusion 66 and extends to the right and upwardly where it makes contact with the base of the transistor 11 at a bonding area 16. The connector 17 also has a bonding area 19 at the lower edge of the cell. The connector 47 extends from a bonding area 68 along the lower edge of the cell to a bonding area 62, and thence upwards where it makes contact with the base of the transistor 12. The connector 47 is also connected with the right end of the diffusion 67 at a bonding area 44. The connector 26 runs from the right end of the diffusion 66 upwards to a bonding area 27 at the upper edge of the cell at a position adjacent the collector contact 52 of the transistor 11. Similarly, the connector 40 extends upwardly from the left end of the diffusion 67 to a bonding area 38 adjacent the collector contact 53 of the transistor 12.

Referring now to Fig. 2 of the drawings, here the cross-sectional view taken along line A—A of Fig. 1 is shown. All of the devices are constructed upon the surface of a P— type semiconductor substrate 71. A heavily doped N+ type semiconductor subcollector region 72 is first formed atop the P— type substrate 71 by well-known semiconductor processes. Next, a lightly doped N— type epitaxial layer 73 is formed, again, by known epitaxial processes. This layer is indicated at 10 in Fig. 1.

Regions 74, 75 and 86 collectively form the isolation between active devices. Regions 86 are formed by known diffusion processes using P type dopant materials (such as Boron) prior to the formation of an N+ region 72. Regions 74 and 75 are constructed using known etching, deposition and oxidization processes to various depths into the substrate 71, subcollector 72 and epitaxial layer 73. Regions 74 and 75 basically consist of insulator type materials, such as silicon oxide ($SiO_2$). The base region 80 of the transistor is formed by diffusing a P type dopant material (e.g. Boron) from the P+ type doped polysilicon layer 79 by known diffusion and high temperature heat cycling processes. The emitter region 81 of the transistor is similarly formed, by diffusing N type dopant materials (e.g. arsenic or phosphorus) from the N+ type doped polysilicon layer 82. Layers 83, 84 and 78 are contact metal layers for emitter, base and collector regions of the transistor, respectively. These metal layers are formed using highly conductive metals such as aluminum or copper by known evaporation processes. Polysilicon layers 79 and 82 are used as connecting layers between metal layers 78, 83 and 84 as shown in Fig. 2, and are also used to form the connectors 17, 26, 34, 40, 47 and 48 described with reference to Fig. 1. Layers 76, 77 and 85 are insulating layers used to isolate connectors from each other as well as to protect the surface of the semiconductor regions. These insulating layers are formed by known deposition and oxidization processes, and are made of materials such as silicon oxide ($SiO_2$), and/or silicon nitride ($Si_3N_4$).

The heavily doped N+ region 87 is formed by known diffusion processes, by diffusing an N type dopant material into the N− type lightly doped epitaxial layer 73. The region 87 provides good ohmic contact to the collector region of the transistor by the metal layer 78.

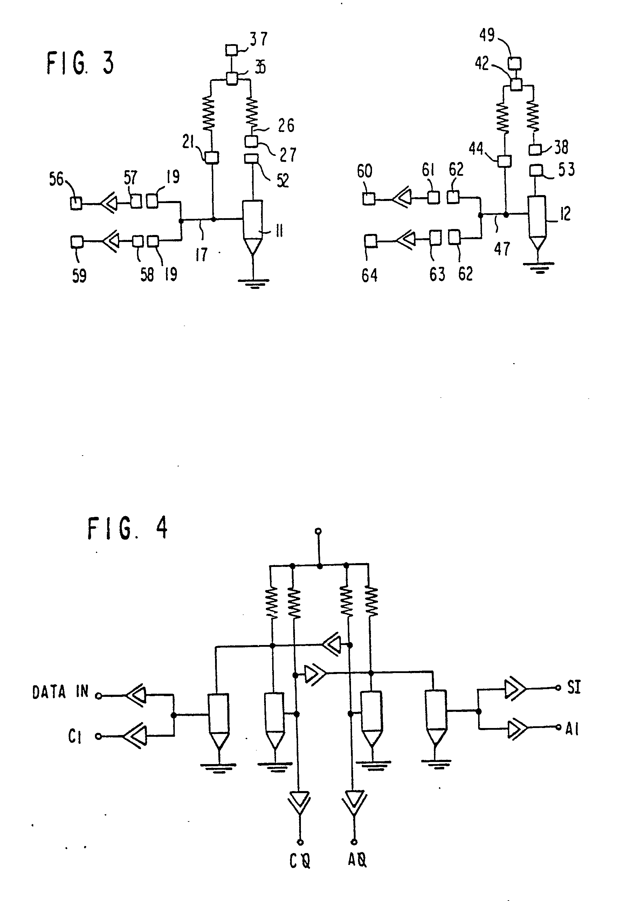

Fig. 3 is a schematic representation of the cell of Fig. 1. In Fig. 3, reference numerals which are the same as those used in Fig. 1 identify corresponding components or elements.

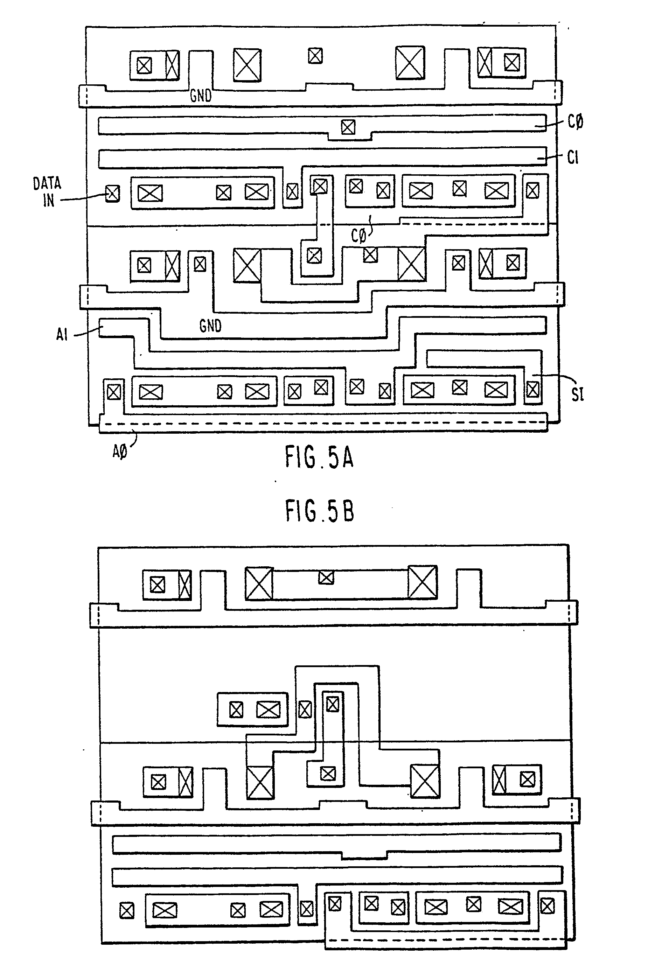

Fig. 4 is a schematic diagram of a common type of latch circuit which can be constructed using two of the cells of Fig. 1. Figs. 5A and 5B are top views of wiring patterns used to interconnect two laterally adjacent cells of the type of Fig. 1. That is, the circuit of Fig. 4 is fabricated simply by forming the wiring patterns of Figs. 5A and 5B over the laterally adjacent cells. Insulating layers (not shown) are formed between the cell and the wiring pattern of Fig. 5A, and between the wiring pattern of Fig. 5A and the wiring pattern of Fig. 5B. Other circuit arrangements are, of course, possible, the circuit of Fig. 4 and the corresponding wiring patterns of Figs. 5A and 5B being given only as examples.

## Claims

1. A semiconductor integrated circuit chip comprising: a plurality of identical cells i.e. multicells (Fig. 1) arranged in matrix form, each of said cells comprising a plurality of diffused areas (e.g. 13, 14, 15, 66 ...) on a surface of said chip, said diffused areas including both active and passive semiconductor device elements; and a plurality of conductive connectors (e.g. 17, 26, 34, 36 ...) formed on the insulated surface of the substrate (10), said connectors having bonding areas (35, 37 ...) located in parallel lines on the surface of the chip, at least some of said bonding areas of some of the connectors being coupled to predetermined ones of the semiconductor elements (e.g. 21—17—16) so as to partially interconnect some of these elements (11, 12), such that space is left for wiring channels between said lines of connector bonding areas on the surface of the chip, said semiconductor elements (e.g. 11, 12, 56, 57 ...) being selectively connectable by later formed conductive layers in said wiring channels to form predetermined circuit configurations.

2. The semiconductor integrated circuit chip of claim 1, wherein said connectors are formed of a polysilicon material.

3. The semiconductor integrated circuit chip of one of the preceding claims, wherein each said cell includes as semiconductor device elements at least two transistors, four diodes and four resistors.

4. The semiconductor integrated circuit chip of one of the preceding claims, wherein each said cell is rectangular in shape, and wherein said bonding areas are arranged along at least three lines, each of said lines running parallel to a long side of said cell, at least one of said lines running approximately through the middle of said cell, and others of said lines lying along opposite sides of said cell.

5. The semiconductor integrated circuit chip of claim 3, wherein said two transistors (11, 12) are formed adjacent one of said opposite sides of said cell aligned with one of said lines, said resistors are formed as elongated diffused areas (66, 67) extending longitudinally aligned with said one of said lines running approximately through the middle of said cell, and said diodes (56, 57 ...) lie along said side of said cell opposite said transistor and aligned with a respective one of said lines.

6. The semiconductor integrated circuit chip of one of the preceding claims, wherein at least some of said connectors (e.g. 26) extend across said cell orthogonal to said long side of said cell and having bonding areas (e.g. 27) adjacent, but not connected to, bonding areas of some of said semiconductor device elements (e.g. 11).

7. The semiconductor integrated circuit chip of claim 3, wherein said four resistors are formed as two diffused areas (66, 67), each center tapped by a bonding area (35, 42) of respective ones of said connectors.

8. The semiconductor integrated circuit chip of one of the preceding claims, further comprising at least one metallization layer for connecting said semiconductor device elements in at least one of a predetermined logic or memory circuit configuration (Figs. 5A, B).

9. The semiconductor integrated circuit chip of one of the preceding claims comprising an array of multicells, each multicell comprising the same components and component layout, some of said components being pre-wired into a basic logic circuit, at least some of the remainder of said components of at least some of said multicells being selectively wired into its respective logic circuit so as to change the functionality of said circuit, and said multicells being connected together to form a system of logic circuits.

## Patentansprüche

1. Integriertes Halbleiterschaltungschip, folgendes enthaltend: mehrere in Matrixform angeordnete identische Zellen, d.h. Multizellen (Fig. 1), von denen jede mehrere diffundierte Bereiche (z.B. 13, 14, 15, 66 ...) auf einer Oberfläche des Chips enthält, welche sowohl aktive wie auch passive Halbleitervorrichtungen umschließen; sowie mehrere leitende Verbindungen (z.B. 17, 26, 34, 36 ...) auf der isolierten Oberfläche des Substrats (10), welche Bindungsbereiche (35, 37 ...) in parallelen Leitungen auf der Chipoberfläche haben, wobei mindestens einige der Bindungsbereiche von einigen der Verbindungen mit bestimmten Halbleiterelementen (z.B. 21—17—16) verbunden sind und somit einige dieser Elemente (11, 12) teilweise miteinander verbinden, so daß Raum verbleibt für Verdrahtungskanäle zwischen den Leitungen der Bindungsbereiche der Verbindungselemente auf der Chipoberfläche, und wobei Halbleiterelemente (z.B. 11, 12, 56, 57 . . .) wahlweise durch später gebildete leitende Schichten in den Verdrahtungskanälen verbindbar sind, um bestimmte Schaltungskonfigurationen herzustellen.

2. Integriertes Halbleiterschaltungschip nach Anspruch 1, in welchen die Verbindungen aus einem Polysiliciummaterial bestehen.

3. Integriertes Halbleiterschaltungschip nach einem der vorhergehenden Ansprüche, in welchem jede Zelle als Halbleitervorrichtungselemente mindestens zwei Transistoren, vier Dioden und vier Widerstände enthält.

4. Integriertes Halbleiterschaltungschip nach einem der vorhergehenden Ansprüche, bei welchem jede der Zellen rechteckig ist und jeder der Bindungsbereiche entlang mindestens drei Leitungen vorgesehen ist, wobei jede Leitung sich parallel zu einer Längsseite der Zelle erstreckt und mindestens eine der Leitungen ungefähr durch die Mitte der Zelle verläuft, und andere entlang entgegengesetzten Seiten der Zelle vorgesehen sind.

5. Integriertes Halbleiterschaltungschip nach Anspruch 3, in welchem zwei Transistoren (11, 12) neben einer der entgegengesetzten Seiten der Zelle in Ausrichtung mit einer der Leitungen vorgesehen sind, und worin die Widerstände als längsförmige diffundierte Bereiche (66, 67) ausgebildet sind, welche sich längs in Ausrichtung mit einer der Leitungen erstrecken, die ungefähr durch die Mitte der Zelle verläuft, und worin die Dioden (56, 57 . . .) entlang der Zellenseite gegenüber dem Transistor und in Ausrichtung mit einer entsprechenden Leitung vorgesehen sind.

6. Integriertes Halbleiterschaltungschip nach einem der vorhergehenden Ansprüche, bei dem mindestens einige der Verbindungen (z.B. 26) sich quer über die Zelle senkrecht zu deren Längsseite erstrecken und Bindungsbereiche (z.B. 27) aufweisen, die neben, jedoch nicht verbunden mit Bindungsbereichen von einigen Halbleitervorrichtungselementen (z.B. 11) vorgesehen sind.

7. Integriertes Halbleiterschaltungschip nach Anspruch 3, bei dem vier Widerstände als zwei Diffusionsbereiche (66, 67) vorgesehen sind, die jeder einen Bindungsbereich (35, 42) als Mittelabgriff von entsprechenden Verbindungen aufweisen.

8. Integriertes Halbleiterschaltungschip nach einem der vorhergehenden Ansprüche, weiterhin umfassend mindestens eine Metallisierungsschicht zur Verbindung der Halbleitervorrichtungselemente in mindestens einer bestimmten logischen oder Speicherkonfiguration (Fign. 5A, B).

9. Integriertes Halbleiterschaltungschip nach einem der vorhergehenden Ansprüche, mit einer Anordnung von Multizellen, von denen jede dieselben Komponenten mit der gleichen Anordnung umfaßt, wobei einige dieser Komponenten zu einer logischen Basisschaltung geschaltet sind, und wobei mindestens einige der verbleibenden Komponenten von mindestens einigen der Multizellen selektiv in der entsprechenden logischen Schaltung vorgesehen sind, um die Funktionalität der Schaltung zu verändern, und wobei die Multizellen zur Bildung eines Systems logischer Schaltungen zusammengeschaltet sind.

**Revendications**

1. Puce de circuit intégré à semiconducteur comprenant:
une pluralité de cellules identiques, c'est-à-dire des multicellules (figure 1) disposées sous forme matricielle, chacune des cellules comprenant une pluralité de zones diffusées (par exemple 13, 14, 15, 66 . . .) sur une surface de la puce, ces zones diffusées incluant des éléments actifs et passifs de dispositif semiconducteur; et
une pluralité de connecteurs conducteurs (par exemple 17, 26, 34, 36 . . .) formés sur la surface isolée du substrat (10), ces connecteurs ayant des surfaces de liaison (35, 37 . . .) disposés selon des lignes parallèles sur la surface de la puce, au moins certaines des zones de liaison de certains des connecteurs étant couplées à certains prédéterminés des éléments semiconducteurs (par exemple 21, 17, 16) de façon à interconnecter partiellement certains de ces éléments (11, 12), de sorte que de l'espace soit laissé pour des canaux de connexion entre les lignes de zones de liaison de connecteurs sur la surface de la puce, les éléments semiconducteurs (par exemple 11, 12, 56, 57 . . .) étant sélectivement connectables par les dernières couches conductrices formées dans les canaux de connexion pour former des configurations de circuit prédéterminées.

2. Puce de circuit intégré à semiconducteur selon la revendication 1, dans laquelle les connecteurs sont constitués de silicium polycristallin.

3. Puce de circuit intégré à semiconducteur selon l'une des revendications précédentes, dans laquelle chacune des cellules comprend comme élément de dispositif semiconducteur au moins deux transistors, quatre diodes et quatre résistances.

4. Puce de circuit à semiconducteur selon l'une des revendications précédentes dans laquelle chaque cellule est de forme rectangulaire et dans laquelle les zones de liaison sont disposées le long d'au moins trois lignes, chacune de ces lignes s'étendant parallèlement à un long côté de la cellule, au moins l'une des lignes s'étendant approximativement au travers du milieu de la cellule, et les autres lignes s'étendant le long de côtés opposés de la cellule.

5. Puce de circuit intégré à semiconducteur selon la revendication 3, dans laquelle les deux transistors (11, 12) sont formés de façon adjacente à l'un des côtés opposés de la cellule aligné avec l'une des lignes, les résistances sont formées en tant que zones diffusées allongées (66,

67) s'étendant de façon alignée longitudinalement avec l'une des lignes s'étendant approximativement à travers le milieu de la cellule, et les diodes (56, 57 . . .) s'étendent le long du côté de la cellule opposé au transistor et aligné avec l'une respective desdites lignes.

6. Puce de circuit intégré à semiconducteur selon l'une des revendications précédentes dans laquelle au moins certains des connecteurs (par exemple 26) s'étendent en travers de la cellule orthogonalement audit long côté de la cellule et ayant des zones de liaison (par exemple 27) adjacentes, mais non connectées, à des zones de liaison de certains des éléments de dispositif semiconducteur (par exemple 11).

7. Puce de circuit intégré à semiconducteur selon la revendication 3, dans laquelle les quatres résistances sont formées en tant que deux zones diffusées (66, 67), chaque centre étant connecté à une zone de liaison (35, 42) de certains respectifs des connecteurs.

8. Puce de circuit intégré à semiconducteur selon l'une des revendications précédentes comprenant en outre au moins une couche de métallisation pour connecter les éléments du dispositif semiconducteur selon au moins une configuration logique prédéterminée ou un circuit de mémoire (figure 5A, B).

9. Puce de circuit intégré à semiconducteur selon l'une des revendications précédentes comprenant un réseau de multicellules,

chaque multicellule comprenant les mêmes composants et la même topographie de composants,

certains des composants étant précâblés en un circuit logique de base,

au moins certains du reste des composants d'au moins certaines des multicellules étant sélectivement connectés en leur circuit logique respectif de façon à modifier la fonctionnalité du circuit, et

les multicellules étant connectées ensemble pour former un système de circuits logiques.

## FIG.1

## FIG.2

1

0 151 267

FIG. 3

FIG. 4

FIG.5A

FIG.5B